# EUROPEAN PATENT APPLICATION

(11) **EP 4 838 906 A2**
(43) Date of publication of application: **11.11.2026**
(21) Application number: 26205637.7
(22) Date of filing: 03.12.2021
(51) Int. Cl.: H04R 17/02

(54) **LOW NOISE PIEZOELECTRIC SENSORS**

(30) Priority: 04.12.2020 US 202063121641 P
(62) Document number(s) of the earlier application(s) in accordance with Art. 76 EPC: 21901571.6 / 4 256 628
(71) Applicant: QUALCOMM Incorporated, San Diego, CA 92121-1714 (US)
(72) Inventor: LITTRELL, Robert J, San Diego, 92121-1714 (US); CORE, Craig, San Diego, 92121-1714 (US)
(74) Representative: Wagner & Geyer

(57) **Abstract**

A low noise piezoelectric sensor, such as a piezoelectric acoustic transducer, includes a first conductive layer, a second conductive layer, and a piezoelectric layer between the first conductive layer and the second conductive layer. The piezoelectric layer comprises aluminum scandium nitride (AIScN) having a scandium content of greater than 15%, in which the scandium content and an aluminum content comprises 100% of the aluminum scandium nitride. In this way, the piezoelectric layer (or the sensor including the piezoelectric layer) achieves a dissipation factor of less than about 0.1%.

## Description

### PRIORITY

This application claims priority to and the benefit of U.S. Provisional Patent Application No. 63/121,641, filed December 4, 2020, the entire contents of which is incorporated herein by reference.

### TECHNICAL FIELD

The present disclosure relates generally to piezoelectric sensors having an improved (e.g., lower) noise floor.

### BACKGROUND

A key metric for sensors of all types is the noise floor, sometimes referred to as the minimum detectable signal or signal-to-noise-ratio (SNR). The noise floor of some piezoelectric microelectromechanical systems (MEMS) sensors is limited by the dissipation factor of the piezoelectric film in combination with the film coupling coefficient and the mechanical design. Dissipation factor, also referred to as the tangent of the loss angle (tan(δ)), is the tangent of the difference in the phase angle between voltage and current applied to a capacitor relative to 90 degrees, the phase angle of a lossless film. Therefore, the dissipation factor is a measure of the energy losses of a film.

### SUMMARY

The techniques described here provide for piezoelectric sensors and other devices having an improved (e.g., lower) noise floor. In an example, the techniques described here include a film stack (e.g., an aluminum scandium nitride (AlScN) film stack) deposited on a wafer (e.g., a silicon (Si) wafer) and released to form a structure (e.g., a cantilever structure) that can be used to create several types of sensors and other devices, including microphones, accelerometers, acoustic transducers, actuators (e.g., speakers, ultrasound transmitters, ultrasound receivers, etc.), and pressure sensors, among others. In an example, the piezoelectric layer(s) of the film stack used to produce the sensor (or the film stack itself) has a dissipation factor (e.g., tan(δ)) of less than about 0.0006 (0.06%), or less than about 0.001 (0.1%). In an example, the piezoelectric layer(s) of the film stack used to produce the sensor (or the film stack itself) has a d₃₁ coupling coefficient with an absolute value greater than about 3.68 pico-Coulombs per Newton (pC/N). In an example, the piezoelectric layer(s) of the film stack used to produce the sensor have at least one AlScN layer with scandium content greater than or equal to about 15%, greater than or equal to about 20%, or greater than or equal to about 30%, in which the scandium content and an aluminum content comprises 100% of the aluminum scandium nitride.

By using a film stack having the above-noted properties and characteristics, the piezoelectric sensors and other devices described here achieve a lower noise floor and greater performance (e.g., higher SNR and lower power consumption) than other sensors that cannot attain such a dissipation factor or coupling coefficient, or both, such as sensors having sputtered piezoelectric films using current technology. In addition, the film stack described here allows sensors to be produced on a small die size and fit into a small package relative to sensors deposited on relatively thick metal that are not appropriate for high performance sensors. The film stack described here is capable of being uniformly deposited on a large wafer (e.g., a 200mm or larger wafer) which allows sensors produced from the film stack to be more manufacturable relative to stacks that can only be uniformly deposited on smaller wafers or substrates.

In general, in an aspect, a device includes a first conductive layer, a second conductive layer, and a piezoelectric layer between the first conductive layer and the second conductive layer, the piezoelectric layer having a dissipation factor of less than about 0.1%.

Implementations of the above aspect can include one or a combination of two or more of the following features. In some examples, the piezoelectric layer includes aluminum scandium nitride (AlScN) having a scandium content of greater than 15%, in which the scandium content and an aluminum content comprises 100% of the aluminum scandium nitride. In some examples, the piezoelectric layer comprises AlScN having a scandium content of greater than 30%, in which the scandium content and an aluminum content comprises 100% of the aluminum scandium nitride. In some examples, the piezoelectric layer has a d₃₁ coupling coefficient having an absolute value greater than about 3.68 pC/N. In some examples, at least one of the first conductive layer or the second conductive layer is a metal layer having a thickness of less than 100nm. In some examples, the piezoelectric layer is a first piezoelectric layer, and the device further includes a third conductive layer, and a second piezoelectric layer between the second conductive layer and the third conductive layer, the second piezoelectric layer having a dissipation factor of less than about 0.1%. In some examples, the device is a microphone, an accelerometer, or a pressure sensor. In some examples, the device is an actuator, such as a speaker, an ultrasound transmitter, or an ultrasound receiver. In some examples, the device includes a cantilever. In some examples, the first conductive layer is deposited on an adhesive layer that comprises titanium, AlScN, aluminum nitride, or chromium.

In general, in an aspect, a device includes a first conductive layer, a second conductive layer, and a piezoelectric layer between the first conductive layer and the second conductive layer, the piezoelectric layer having aluminum scandium nitride having a scandium content of greater than 15%, in which the scandium content and an aluminum content comprises 100% of the aluminum scandium nitride.

Implementations of the above aspect can include one or a combination of two or more of the following features. In some examples, the piezoelectric layer includes AlScN having a scandium content of greater than 30%, in which the scandium content and an aluminum content comprises 100% of the aluminum scandium nitride. In some examples, the piezoelectric layer includes a dissipation factor of less than about 0.1%. In some examples, the piezoelectric layer includes a d₃₁ coupling coefficient having an absolute value greater than about 3.68 pC/N. In some examples, at least one of the first conductive layer or the second conductive layer is a metal layer having a thickness of less than 100nm. In some examples, the piezoelectric layer is a first piezoelectric layer, and the device further includes a third conductive layer, and a second piezoelectric layer between the second conductive layer and the third conductive layer, the second piezoelectric layer having a dissipation factor of less than about 0.1%. In some examples, the device is a microphone, an accelerometer, or a pressure sensor. In some examples, the device is a speaker, an ultrasound transmitter, or an ultrasound receiver. In some examples, the device includes a cantilever. In some examples, the first conductive layer is deposited on an adhesive layer that comprises titanium, AlScN, aluminum nitride, or chromium.

In general, in an aspect, a method of fabricating a device includes depositing a first conductive layer on a substrate, depositing a piezoelectric layer on the first conductive layer, the piezoelectric layer including AlScN having a scandium content of greater than 15%, in which the scandium content and an aluminum content comprises 100% of the aluminum scandium nitride, and depositing a second conductive layer on the piezoelectric layer.

Implementations of the above aspect can include one or a combination of two or more of the following features. In some examples, the substrate is a silicon wafer having at least a 200mm diameter. In some examples, the piezoelectric layer is deposited by pulsed laser deposition. In some examples, the piezoelectric layer includes at least one of a dissipation factor of less than about 0.1% or a d₃₁ coupling coefficient having an absolute value greater than about 3.68 pC/N. In some examples, the piezoelectric layer comprises aluminum scandium nitride having a scandium content of greater than 30%, in which the scandium content and an aluminum content comprises 100% of the aluminum scandium nitride. In some examples, the method includes depositing an oxide layer on the substrate, depositing an adhesive layer on the oxide layer, the adhesive layer comprising titanium, aluminum scandium nitride, aluminum nitride, or chromium, and depositing the first conductive layer on the adhesive layer. In some examples, the method includes, processing the first conductive layer to form at least one gap in the first conductive layer before depositing the piezoelectric layer. In some examples, the method includes processing the deposited material to produce one or more structures that form a piezoelectric sensor. In some examples, at least one of the one or more structures is a cantilever, and the piezoelectric sensor is a microphone, an accelerometer, or a pressure sensor. In some examples, the piezoelectric sensor is a speaker, an ultrasound transmitter, or an ultrasound receiver.

The details of one or more implementations are set forth in the accompanying drawings and the description below. Other features and advantages will be apparent from the description and drawings, and from the claims.

### BRIEF DESCRIPTION OF DRAWINGS

FIG. 1 illustrates an example piezoelectric film stack.
FIGS. 2A and 2B illustrate different views of an example piezoelectric sensor.
FIGS. 3A and 3B illustrate different views of an example piezoelectric sensor.
FIG. 4 is a graph of tan(δ) values versus capacitance.
FIG. 5 is a graph of deflection versus distance.
FIG. 6 illustrates an example process for fabricating a low noise piezoelectric sensor.

Like reference symbols in the various drawings indicate like elements.

### DETAILED DESCRIPTION

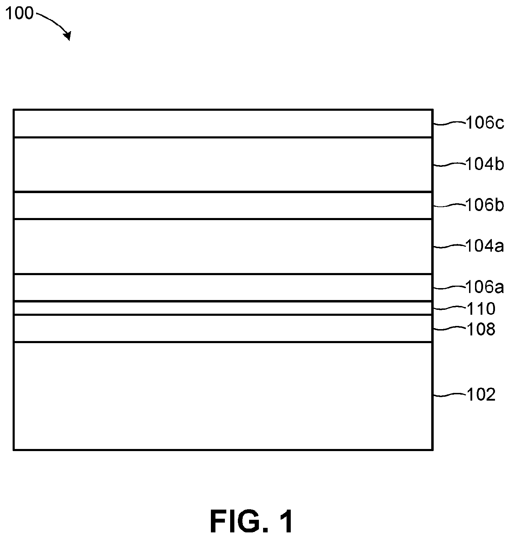

FIG. 1 shows an example film stack 100 used to produce a piezoelectric MEMS sensor in accordance with the present disclosure. In this example, the stack 100 includes a substrate 102, such as a silicon substrate (e.g., a 200mm silicon wafer), on which two piezoelectric layers 104a, 104b (referred to collectively as "piezoelectric layers 104") and three electrode layers 106a, 106b, 106c (referred to collectively as "electrode layers 106") are deposited in an alternating fashion. A different number of piezoelectric layers 104 or electrode layers 106 can be used in some examples. An insulating layer 108 (e.g., an oxide layer, such as silicon dioxide, that is about 500nm thick) is optionally included to separate the piezoelectric layers 102 and the electrode layers 104 from the substrate 106. In some examples, the stack 100 can include additional layers, such as a layer 110 disposed between the insulating layer 108 and the first electrode layer 104a.

In an example, some or all of the piezoelectric layers 104 comprise aluminum scandium nitride (AlScN) with greater than or equal to about 15% scandium (e.g., the atomic percentage of scandium relative to aluminum in the layer, ignoring the nitrogen). In other words, in this example, scandium would account for 15% of the total number of atoms in the AlScN thin film, assuming that the total number of aluminum and scandium atoms comprises 100% of the atoms in the AlScN thin film. In some cases, some or all of the piezoelectric layers 104 comprise AlScN with a different concentration of scandium, such as greater than or equal to about 20% scandium, greater than or equal to about 30% scandium, or greater than or equal to about 40% scandium. In an example, the piezoelectric layer comprises AlScN with low defects.

In an example, some or all of the piezoelectric layers 104 comprise AlXN, where X is a rare-earth element. The concentration of X (e.g., 15%, 20%, 30%, 40%, etc.) can be selected such that the piezoelectric layer 104 (or the stack 100 including the piezoelectric layer) has a dissipation factor (e.g., tan(δ)) of less than about 0.0004 (0.04%), less than about 0.0006 (0.06%), or less than about 0.001 (0.1%), or a d₃₁ coupling coefficient with an absolute value greater than about 3.68 pC/N, or both. In an example, the dissipation factor is measured at a frequency that is relevant to the piezoelectric sensor, such as 1kHz or 10kHz, among other frequencies. In some examples, the dissipation factor is measured at a frequency of the piezoelectric layer (or a structure, such as a piezoelectric sensor, formed from the piezoelectric layer), such as a first order resonant frequency, a second order resonant frequency, or a third order resonant frequency, among others.

The piezoelectric layers 104 are deposited onto the substrate 102 (e.g., a 200mm silicon wafer, which is optionally coated with the insulating layer 108 and/or the layer 110) using pulsed laser deposition, physical vapor deposition, or another piezoelectric film deposition technique. In an example, each of the piezoelectric layers 104 are less than 1µm thick, such as about 200nm thick, about 300nm thick, about 450nm thick, about 650nm thick, or about 900nm thick.

The electrode layers 106 can be formed from any conductor. In an example, the electrode layers 106 comprise platinum (Pt), molybdenum (Mo), ruthenium (Ru), or combinations of them, among others. In an example, some or all of the electrode layers 106, such as the first electrode layer 106a and the third electrode layer 106c, are less than about 100nm thick, less than about 20nm thick, or less than about 10nm thick. The electrode layers 106 can be deposited or otherwise formed using known techniques.

In some examples, the layer 110 disposed between the insulating layer 108 and the first electrode layer 106a can comprise a titanium (Ti) layer that is about 15nm. Alternatively, the layer 110 can comprise other materials, such as AlScN, aluminum nitride (AlN), chromium (Cr), or another adhesion metal, among other materials.

In a particular example, the stack 100 comprises: a silicon substrate 102; a silicon dioxide (SiO2) insulating layer 108 having a thickness of about 500nm that is formed on the substrate 102; a Ti layer 110 having a thickness of about 15nm that is formed on the insulating layer 108; three Pt electrode layers 106 that are each about 100nm thick; and two piezoelectric layers 104 each comprising AlScN with about 30% scandium and having a thickness of about 450nm, 650nm, or 900nm, among other thicknesses. In this example, the three Pt electrode layers 106 and the two AlScN piezoelectric layers 104 are deposited in an alternating fashion, thereby forming a stack 100 comprising Si/SiO2/Ti/Pt/AlScN/Pt/AlScN/Pt.

In some examples, the stack 100 can include additional or fewer piezoelectric layers and electrode layers deposited in an alternating fashion. For instance, in some examples, the stack 100 can include one piezoelectric layer 104 and two electrode layers 106, thereby forming a stack 100 comprising Si/SiO2/Ti/Pt/AlScN/Pt. In some examples, the stack 100 can include three piezoelectric layers 104 and four electrode layers 106, thereby forming a stack 100 comprising Si/SiO2/Ti/Pt/AlScN/Pt/AlScN/Pt/AlScN/Pt.

In some examples, the stack 100 can be formed from other materials. For instance, in some examples, releasing a device formed in the stack 100 from the oxide (SiO2) layer 108 may require a chemical that etches the Ti adhesion layer 110 at a high rate. Accordingly, the Ti layer 110 can be replaced with AlScN, AlN, Cr, or another adhesion metal, thereby forming a stack 100 comprising Si/SiO2/AlScN/Pt/AlScN/Pt, Si/SiO2/A;N/Pt/AlScN/Pt, or Si/SiO2/Cr/Pt/AlScN/Pt, among others, each of which can include a different number of piezoelectric and electrode layers. In some examples, some or all of the Pt electrode layers 106 are replaced with Mo, Ru, or another conductor, thereby forming a stack 100 comprising Si/SiO2/Ti/Mo/AlScN/Mo or Si/SiO2/Ti/Ru/AlScN/Ru, among others, each of which can include a different number of piezoelectric and electrode layers. Other examples of the stack 100, including combinations of the above-noted modifications, are also within the scope of the present disclosure.

Once the stack 100 has been formed, portions of the stack 100 can be processed and released (e.g., through dry etching, wet etching, etc.) to form one or more structures (e.g., one or more cantilever structures, diaphragm structures, fixed-fixed beam structures, plate structures, or combinations of them, among others) that are used to create one or more piezoelectric MEMS sensors, such as microphones, accelerometers, acoustic transducers, pressure sensors, speakers, ultrasound transmitters, or ultrasound receivers, among others. Other sensors created from the stack 100 are also within the scope of the present disclosure.

In an example, the stack 100 is processed and released to form multiple cantilevers that produce a diaphragm used to create a microphone or another device, such as described in U.S. Patent Application No. 16/353,934, titled "Acoustic Transducer with Gap-Controlling Geometry and Method of Manufacturing an Acoustic Transducer," the entire contents of which is incorporated herein by reference.

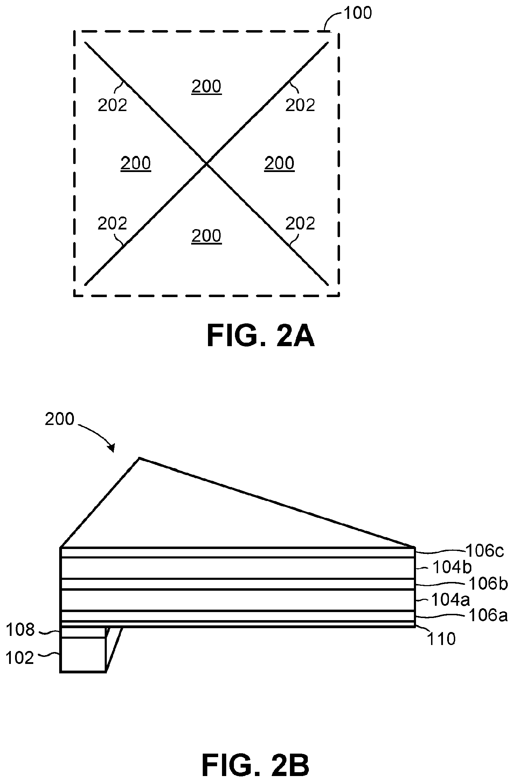

For example, referring to FIGS. 2A and 2B, the stack 100 can be processed to form a plurality of cantilevered beams 200 arranged in a gap-controlling geometry that minimizes the resultant gap 202 between each of the cantilevered beams 200. To create the gaps 202 that define the gap-controlling geometry of the cantilevered beams 200, the stack 100 can be processed by etching the gaps 202 through the deposited layers (e.g. with dry etching, wet etching, reactive ion etching, ion milling, or another etching method). In some examples, each of the gaps 202 have a thickness of about 1µm or less. Additionally, in some examples, the gaps 202 bisect each other to form substantially triangular cantilevered beams 200, but may alternately intersect at other locations to form the desired gap-controlling geometry. In some examples, at least two bisecting gaps 200 are created, such that at least four triangular cantilevered beams 200 are formed. Alternatively, three, four, or any number of gaps 202 may be created to form any number of cantilevered beams 200.

Once the gaps 202 are formed, the cantilevered beams 200 can be released from the substrate (e.g., the substrate 102 of the stack 100). In this way, the cantilevered beams 200 can expand, contract, or bend as necessary to relieve residual stress, while the gap-controlling geometry maintains the desired acoustic resistance. In some examples, the cantilevered beams 200 are released from the substrate by removing the substrate and/or the oxide layer from underneath the cantilevered beams 200, such as by deep reactive dry etching, wet etching, ion etching, electric discharge machining, micromachining processes, or any other processing method that releases the cantilevered beams 200 from the substrate. In some examples, the cantilevered beams 200 can be released from the substrate (e.g., by etching away a previously-deposited sacrificial layer) and subsequently reattached, either to the same substrate or to a different substrate. After the cantilevered beams 200 have been released, they can serve as an acoustic transducer (e.g., a microphone, a speaker, etc.) that transforms acoustic pressure into electrical signals, among other things.

In an example, the stack 100 is processed and released to form one or more cantilevers that create a low noise voice accelerometer as described in U.S. Patent Application No. 16/900,185, titled "Piezoelectric Accelerometer with Wake Function," the entire contents of which is incorporated herein by reference.

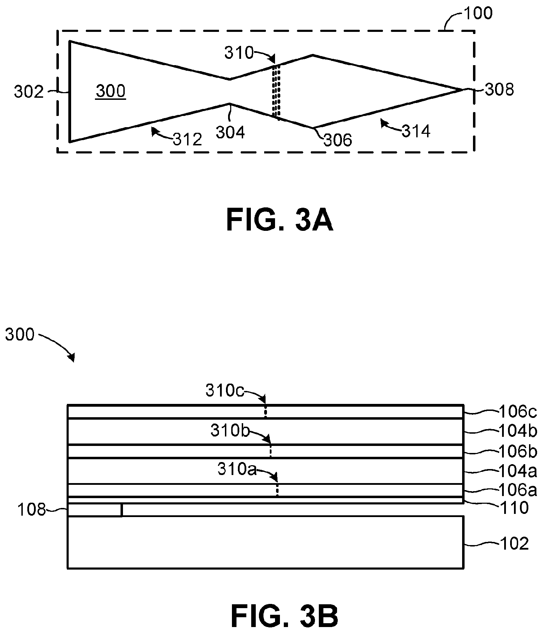

For example, referring to FIGS. 3A and 3B, the stack 100 can be processed and released to produce one or more cantilevered beams 300 that form a low noise voice accelerometer. In this example, the cantilevered beam 300 includes a base region 302 attached to a substrate (e.g., the substrate 102 of the stack 100). The base region 302 can taper to a narrow neck region 304. The stress in this tapering region is approximately constant, and much higher than in the rest of the cantilevered beam 300. From the narrow neck region 304, the cantilevered beam 300 expands to a wide region 306, and from the wide region 306, tapers to a tip 308. In some examples, the cantilevered beam 300 can include a mass element (not shown) disposed, for example, at the tip 308 of the cantilevered beam 300. The tapered structure described above (and, optionally, the mass element) helps uniformly distribute stress along the cantilevered beam 300. In general, the structure of the cantilevered beam 300 can be formed through etching, micromachining, or any combination thereof.

In some examples, the cantilevered beam 300 includes one or more breaks 310 (e.g., a break 310a in the electrode layer 106a, a break 310b in the electrode layer 310b, and/or a break 310c in the electrode layer 106c). The breaks 310 can be electrically isolating regions (e.g., removed portions of the respective electrode layer 106), which may be filled in with piezoelectric material from the piezoelectric layers 104. In this way, the breaks 310 form an active portion 312 of the cantilevered beam 300 (e.g., a portion that contributes to the output signal produced by the cantilevered beam 300 in response to input stimuli), and an inactive portion 314 of the cantilevered beam 300 (e.g., a portion that does not contribute to the output).

In some examples, after forming the above-noted structure, the cantilevered beam 300 can be released from the substrate. In some examples, the beam 300 is released by removing (e.g., etching away) a portion of the oxide layer (e.g., the layer 108). In this way, the oxide layer serves as a spacer between the substrate and the remainder of the cantilevered beam 300 such that the beam does not touch the substrate in a quiescent state. In some examples, the cantilevered beam 300 is released by removing a portion of the substrate (alone or in addition to the oxide layer).

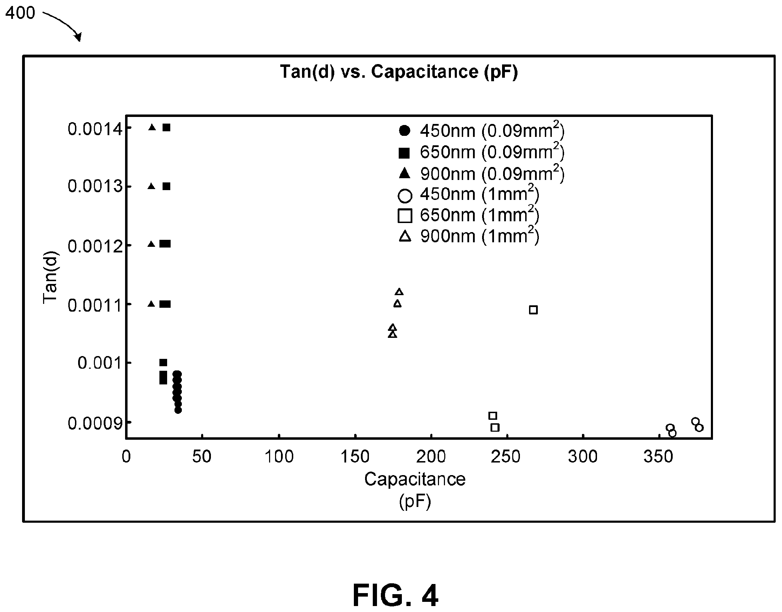

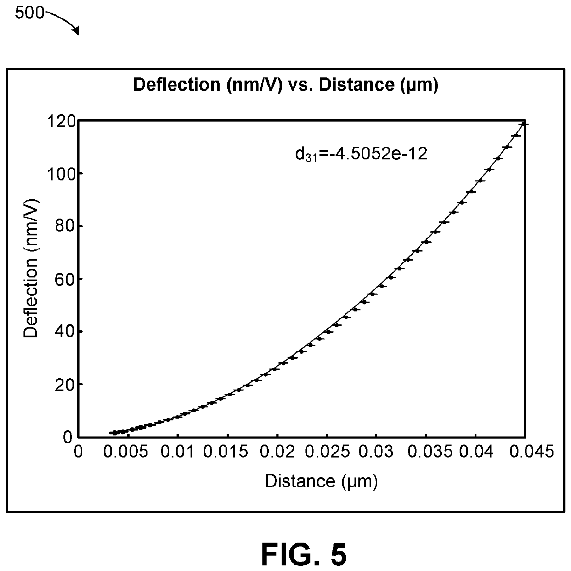

FIGS. 4 and 5 show measured film properties for an example film stack similar to the stack shown in FIG. 1. In particular, FIG. 4 illustrates a graph 400 of the dissipation factor (e.g., tan(δ)) versus the capacitance of the AlScN piezoelectric layer with about 30% scandium for different thicknesses (e.g., 450nm, 650nm, and 900nm). FIG. 5 illustrates a graph 500 of the deflection (in nm/V) as a function of the distance for a stack having a single piezoelectric layer formed from AlScN with about 20% scandium. In FIG. 5, a regression line shows the d₃₁ coupling coefficient for the piezoelectric layer (e.g., the piezoelectric constant relating mechanical strain and applied electric field, defined as the ratio of strain to field, where the first subscript indicates the direction of the field and the second the direction of the resulting strain, expressed in m/V).

The following table shows example test results for various implementations of the stack 100. As shown in the table, pulsed laser deposition (PLD) consistently gives the lowest (best) tan(δ) values. In addition, a stack comprising Si/SiO2/Ti/Pt/AlScN with 30% scandium can produce a tan(δ) value of 0.0004, which is the lowest (best) overall.

| Trial Number | Deposition Technique | Stack | Sc Percentage | AlScN Tan(d) |
|---|---|---|---|---|
| 1 | PLD | Si/SiO2/Ti/Pt/AlScN/Pt | 30 | 0.0004 |
| 2 | PLD | SI/SiO2/Ti/Pt/AlScN/Pt/AlScN/Pt | 30 | 0.0008/0.0008 |
| 3 | PLD | Si/SiO2/Ti/Pt/AlScN/Pt | 30 | 0.0009 |
| 4 | PLD | Si/SiO2/Ti/Pt/AlScN/Pt | 40 | 0.0010 |
| 5 | PLD | Si/SiO2/AlN/Mo/AlScN/Mo | 30 | 0.0012 |
| 6 | Sputtered | Si/SiO2/AlN/Mo/AlScN/Mo | 30 | 0.0029 |
| 7 | Sputtered | Si/SiO2/AlN/Ru/AlScN/Ru | 30 | 0.0023 |
| 8 | Sputtered | Si/SiO2/AlN/Mo/AlScN/Mo | 20 | 0.0013 |
| 9 | Sputtered | Si/SiO2/AlN/Mo/AlScN/Mo | 20 | 0.0023 |

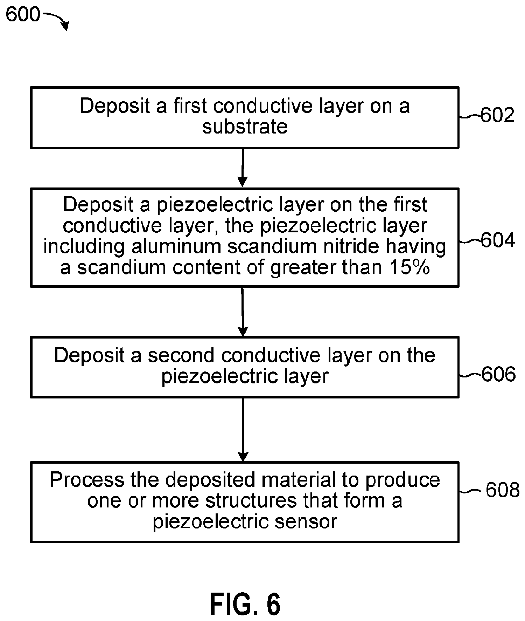

FIG. 6 illustrates an example process 600 for fabricating a low noise piezoelectric sensor in accordance with the techniques described here. At 602, a first conductive layer is deposited on a substrate. In some examples, the substrate is a silicon wafer having a diameter greater than or equal to 200mm. In some examples, the substrate has an insulating layer (e.g., an oxide layer) and/or an adhesive layer comprising Ti, AlScN, AlN, Cr, or another adhesive metal, such that the first conductive layer is deposited on the insulating layer or the adhesive layer. In some examples, the conductive layer includes Pt, Mo, Ru, or another conductive material. In some examples, the first conductive layer is partially etched away prior to deposition of the piezoelectric layer in order to define one or more breaks or gaps in the first conductive layer (e.g., as described above with reference to FIGS. 3A and 3B).

A piezoelectric layer is deposited on the first conductive layer (604). The piezoelectric layer can include AlScN having greater than or equal to about 15% scandium, greater than or equal to about 20% scandium, greater than or equal to about 30% scandium, or greater than or equal to about 40% scandium, in which the scandium content and an aluminum content comprises 100% of the aluminum scandium nitride. In some examples, the piezoelectric layer is deposited by pulsed laser deposition. In some examples, the piezoelectric layer includes AlXN, where X is a rare-earth element. In some examples, the piezoelectric layer (or the film stack including the piezoelectric layer) has a dissipation factor of less than about 0.1% or a d₃₁ coupling coefficient with an absolute value greater than about 3.68 pC/N, or both.

A second conductive layer is deposited on the piezoelectric layer (606). The second conductive layer can be the same or different from the first conductive layer. In some examples, the second conductive layer includes Pt, Mo, Ru, or another conductive material. In some examples, additional piezoelectric and conductive layers can be deposited on the second conductive layer in an alternating fashion. In some examples, the second conductive layer (and any additional conductive layers) are partially etched away (e.g., prior to deposition of a subsequent piezoelectric layer) in order to define one or more breaks or gaps in the respective conductive layer.

At 608, the deposited material is processed and released (e.g., through dry etching, wet etching, etc.) to produce one or more structures (e.g., one or more cantilever structures, diaphragm structures, fixed-fixed beam structures, plate structures, or combinations of them, among others) that form a piezoelectric sensor, such as a microphone, an accelerometer, an acoustic transducer, a pressure sensor, a speaker, an ultrasound transmitter, or an ultrasound receiver, among others.

A number of embodiments have been described. Nevertheless, it will be understood that various modifications may be made without departing from the spirit and scope of the claims and the examples of the techniques described herein.

### Further Summary of the Invention

1. A device, comprising:
   a first conductive layer;
   a second conductive layer; and
   a piezoelectric layer between the first conductive layer and the second conductive layer, the piezoelectric layer comprising a dissipation factor of less than about 0.1%.
2. The device of 1, wherein the piezoelectric layer comprises aluminum scandium nitride having a scandium content of greater than 15%, wherein the scandium content and an aluminum content comprises 100% of the aluminum scandium nitride.
3. The device of 1, wherein the piezoelectric layer comprises aluminum scandium nitride having a scandium content of greater than 30%, wherein the scandium content and an aluminum content comprises 100% of the aluminum scandium nitride.
4. The device of any of 1-3, wherein the piezoelectric layer comprises a d₃₁ coupling coefficient having an absolute value greater than about 3.68 pC/N.
5. The device of any of 1-4, wherein at least one of the first conductive layer or the second conductive layer comprises a metal layer having a thickness of less than 100nm.
6. The device of any of 1-5, wherein the piezoelectric layer comprises a first piezoelectric layer, the device further comprising:
   a third conductive layer; and
   a second piezoelectric layer between the second conductive layer and the third conductive layer, the second piezoelectric layer having a dissipation factor of less than about 0.1%.
7. The device of any of 1-6, wherein the device comprises a microphone, an accelerometer, a pressure sensor, a speaker, an ultrasound transmitter, or an ultrasound receiver.
8. The device of any of 1-7, wherein the device comprises a cantilever.
9. The device of any of 1-8, wherein the first conductive layer is deposited on an adhesive layer.
10. The device of 9, where the adhesive layer comprises titanium, aluminum scandium nitride, aluminum nitride, or chromium.
11. A device, comprising:
   a first conductive layer;
   a second conductive layer; and
   a piezoelectric layer between the first conductive layer and the second conductive layer, the piezoelectric layer comprising aluminum scandium nitride having a scandium content of greater than 15%, wherein the scandium content and an aluminum content comprises 100% of the aluminum scandium nitride.
12. The device of 11, wherein the piezoelectric layer comprises aluminum scandium nitride having a scandium content of greater than 30%, wherein the scandium content and an aluminum content comprises 100% of the aluminum scandium nitride.
13. The device of any of 11-12, wherein the piezoelectric layer comprises a dissipation factor of less than about 0.1%.
14. The device of any of 11-13, wherein the piezoelectric layer comprises a d₃₁ coupling coefficient having an absolute value greater than about 3.68 pC/N.
15. The device of any of 11-14, wherein at least one of the first conductive layer or the second conductive layer comprises a metal layer having a thickness of less than 100nm.
16. The device of any of 11-15, wherein the piezoelectric layer comprises a first piezoelectric layer, the device further comprising:
   a third conductive layer; and
   a second piezoelectric layer between the second conductive layer and the third conductive layer, the second piezoelectric layer having a dissipation factor of less than about 0.1%.
17. The device of any of 11-16, wherein the device comprises a microphone, an accelerometer, a pressure sensor, a speaker, an ultrasound transmitter, or an ultrasound receiver
18. The device of any of 11-17, wherein the device comprises a cantilever.
19. The device of 18, wherein the first conductive layer is deposited on an adhesive layer.
20. The device of 19, where the adhesive layer comprises titanium, aluminum scandium nitride, aluminum nitride, or chromium.
21. A method of fabricating a device, comprising:
   depositing a first conductive layer on a substrate;
   depositing a piezoelectric layer on the first conductive layer, the piezoelectric layer comprising aluminum scandium nitride having a scandium content of greater than 15%, wherein the scandium content and an aluminum content comprises 100% of the aluminum scandium nitride; and
   depositing a second conductive layer on the piezoelectric layer.
22. The method of 21, wherein the substrate comprises a silicon wafer having at least a 200mm diameter.
23. The method of any of 21-22, wherein the piezoelectric layer is deposited by pulsed laser deposition.
24. The method of any of 21-23, wherein the piezoelectric layer comprises at least one of a dissipation factor of less than about 0.1% or a d₃₁ coupling coefficient having an absolute value greater than about 3.68 pC/N.
25. The method of any of 21-24, wherein the piezoelectric layer comprises aluminum scandium nitride having a scandium content of greater than 30%, wherein the scandium content and an aluminum content comprises 100% of the aluminum scandium nitride.
26. The method of any of 21-25, further comprising:
   depositing an oxide layer on the substrate;
   depositing an adhesive layer on the oxide layer, the adhesive layer comprising titanium, aluminum scandium nitride, aluminum nitride, or chromium; and
   depositing the first conductive layer on the adhesive layer.
27. The method of any of 21-26, further comprising:
   before depositing the piezoelectric layer, processing the first conductive layer to form at least one gap in the first conductive layer.
28. The method of any of 21-27, further comprising:
   processing the deposited material to produce one or more structures that form a piezoelectric sensor.
29. The method of 28, wherein at least one of the one or more structures comprises a cantilever.
30. The method of 28, wherein the piezoelectric sensor comprises a microphone, an accelerometer, a pressure sensor, a speaker, an ultrasound transmitter, or an ultrasound receiver

## Claims

1. A device (100), comprising:
a first conductive layer (106a);
a second conductive layer (106b); and
a piezoelectric layer (104a) between the first conductive layer and the second conductive layer, the piezoelectric layer comprising aluminum scandium nitride having a scandium content of greater than 40%, wherein the scandium content and an aluminum content comprise 100% of the metal content of the aluminum scandium nitride.

2. The device of claim 1, wherein the piezoelectric layer has a dissipation factor of less than 0.1%.

3. The device (100) of any of claims 1-2, wherein the piezoelectric layer has a d₃₁ coupling coefficient having an absolute value greater than 3.68 pC/N.

4. The device (100) of any of claims 1-3, wherein at least one of the first conductive layer (106a) or the second conductive layer (106b) comprises a metal layer having a thickness of less than 100 nm.

5. The device (100) of any of claims 1-4, wherein the piezoelectric layer comprises a first piezoelectric layer, the device further comprising:
a third conductive layer (106c); and
a second piezoelectric layer (104b) between the second conductive layer and the third conductive layer, the second piezoelectric layer having a dissipation factor of less than 0.1%.

6. The device (100) of any of claims 1-5, wherein the device comprises a microphone, an accelerometer, a pressure sensor, a speaker, an ultrasound transmitter, an ultrasound receiver or a cantilever.

7. The device (100) of any of claims 1-6, wherein the first conductive layer is deposited on an adhesive layer (110), wherein the adhesive layer comprises titanium, aluminum scandium nitride, aluminum nitride, or chromium.

8. A method (600) of fabricating a device (100), comprising:
depositing (602) a first conductive layer(106a) on a substrate;
depositing (604) by pulsed laser deposition a piezoelectric layer (104a) on the first conductive layer, the piezoelectric layer comprising aluminum scandium nitride having a scandium content of greater than 15%, wherein the scandium content and an aluminum content comprise 100% of the metal content of the aluminum scandium nitride; and
depositing (606) a second conductive layer (106b) on the piezoelectric layer.

9. The method (600) of claim 8, wherein the substrate comprises a silicon wafer having a diameter of at least 200nm.

10. The method (600) of any of claims 8-9, wherein the piezoelectric layer (104a) has at least one of a dissipation factor of less than 0.1% or a d31 coupling coefficient having an absolute value greater than 3.68 pC/N.

11. The method (600) of any of claims 8-10, wherein the piezoelectric layer (104a) comprises aluminum scandium nitride having a scandium content of greater than 40%,

12. The method of any of claims 8-11, further comprising:
depositing an oxide layer on the substrate;
depositing an adhesive layer (110) on the oxide layer, the adhesive layer comprising titanium, aluminum scandium nitride, aluminum nitride, or chromium; and
depositing the first conductive layer on the adhesive layer.

13. The method of any of claims 8-12, further comprising:
before depositing the piezoelectric layer (104a), processing the first conductive layer (106a) to form at least one gap (202) in the first conductive layer.

14. The method of any of claims 8-13, further comprising:
processing the deposited material to produce one or more structures that form a piezoelectric sensor.

15. The method of claim 14, wherein at least one of the one or more structures comprises a cantilever.
